# EUROPÄISCHE PATENTANMELDUNG

(11) **EP 1 684 567 A2**
(43) Veröffentlichungstag der Anmeldung: **26.07.2006**
(21) Anmeldenummer: 05112556.5
(22) Anmeldetag: 21.12.2005
(51) Int. Cl.: H05K 13/04

(54) **Zuführeinrichtung für elektrische Bauelemente**

(30) Priorität: 19.01.2005 DE 102005002568
(71) Anmelder: SIEMENS AKTIENGESELLSCHAFT, 80333 München (DE)
(72) Erfinder: Fischer, Christoph, 82538 Geretsried (DE); Liebeke, Thomas, 85521 Ottobrunn (DE)

(57) **Zusammenfassung**

Eine Zuführeinrichtung (1) für elektrische Bauelemente umfasst ein Transportrad (3) zum Transportieren eines mit Perforationen (6) versehenen Bauelementegurts (5), welches an seinem Außenumfang Stifte (4) aufweist, und eine Gurtauflageeinrichtung (7), auf welcher der Bauelementegurt (5) aufliegt, wobei die Gurtauflageeinrichtung (7) und das Transportrad (3) relativ zueinander beweglich gelagert sind, um die Perforationen (6) wahlweise mit den Stiften (4) des Transportrads (3) in Eingriff zu bringen oder von den Stiften (4) zu trennen.

## Beschreibung

Die Erfindung bezieht sich auf eine Zuführeinrichtung für elektrische Bauelemente.

Bei Bestückungsautomaten zum Bestücken von Substraten mit elektrischen Bauelementen werden seitlich einer Transportstrecke für die Substrate Zuführeinrichtungen für elektrische Bauelemente angeordnet. Ein durch ein Positioniersystem verfahrbarer Bestückkopf holt die elektrischen Bauelemente von einer in einem Abholbereich angeordneten Zuführeinrichtung ab, verfährt diese in den Bestückbereich, in dem das zu bestückende Substrat bereitgestellt wird, und setzt das elektrische Bauelement auf dem Substrat ab. Eine derartige Zuführeinrichtung wird beispielsweise in der Offenlegungsschrift WO 02/080643 beschrieben. Die Bauelemente sind gewöhnlich in den Taschen eines Bauelementegurtes gelagert, der seitliche Perforationen aufweist. Die Zuführeinrichtung verfügt über ein Transportrad, welches an seinem Außenumfang Stifte aufweist, die in die Perforationen des Bauelementegurtes eingreifen, um die in den Taschen lagernden Bauelemente schrittweise zu einer Abholstelle der Zuführeinrichtung zu transportieren, wo die Bauelemente vom Bestückkopf aufgenommen werden.

Bei einem Wechsel der Bauelementegurte ist es notwendig, den auszutauschenden Gurt aus der Zuführeinrichtung zu entnehmen und anschließend den neuen Gurt in die Zuführeinrichtung einzuführen. Dabei müssen die Perforationen des auszutauschenden Gurtes von den Stiften des Transportrades gelöst und die Perforationen des neuen Gurtes korrekt mit den Stiften des Transportrades in Eingriff gebracht werden. Oft ist die Stelle, an der das Transportrad mit dem Gurt in Eingriff steht, sehr schlecht zugänglich. Im Fall, dass die Zuführeinrichtung zum Gurtwechsel von der Stromversorgung getrennt werden muss, ist eine den Wechselvorgang unterstützende elektrische Betätigung des Transportrades nicht mehr möglich. Ferner sollte ein unmittelbares Anfassen des Gurtes vermieden werden, um einen Verlust von Bauteilen zu verhindern.

Es ist deshalb die Aufgabe der vorliegenden Erfindung, eine Zuführeinrichtung für elektrische Bauteile zu liefern, bei der ein Gurtwechsel leichter durchführbar ist.

Diese Aufgabe wird durch die Zuführeinrichtung gemäß dem unabhängigen Anspruch 1 gelöst.

Gemäß dem unabhängigen Anspruch 1 verfügt die Zuführeinrichtung über eine Gurtauflageeinrichtung und ein Transportrad, wobei beide relativ zueinander derart beweglich gelagert sind, dass die Perforationen des Bauelementegurtes mit den Stiften des Transportrades in Eingriff gebracht oder von den Stiften getrennt werden können. Dabei kann entweder die Gurtauflageeinrichtung oder das Transportrad beweglich gelagert sein. Bei einem Wechsel des Bauelementegurtes werden die Gurtauflageeinrichtung und das Transportrad relativ zueinander derart bewegt, dass die Perforationen des auszutauschenden Bauelementegurtes von den Stiften des Transportrades gelöst werden, wodurch es leicht möglich ist, den auszutauschenden Gurt aus der Zuführeinrichtung zu ziehen. Dabei muss nicht an die Eingriffsstelle des Transportrades in den Gurt zugriffen werden. Ein ungewollter Verlust insbesondere von kleinen Bauelementen wird dadurch weitgehend vermieden. Gleichzeitig ist der neue Bauelementegurt einfach in die Zuführeinrichtung einzuführen, da dieser über die Gurtauflageeinrichtung gleitet, ohne durch die Stifte des Transportrads behindert zu werden. Um die Perforationen des neuen Bauelementegurts mit den Stiften des Transportrades in Eingriff zu bringen, müssen lediglich die Gurtauflageeinrichtung und das Transportrad entsprechend relativ zueinander bewegt werden. Da die Bauelementegurte während des Wechselvorgangs von den Stiften des Transportrads getrennt sind, ist der Wechsel des Bauelementegurts auch bei einer von der Stromversorgung getrennten Zuführeinrichtung problemlos möglich.

In einer Ausgestaltung der Zuführeinrichtung gemäß Anspruch 2 wird die bewegliche Gurtauflageeinrichtung durch eine erste Feder in eine Position gedrängt, in der die Perforationen des Bauelementegurtes mit den Stiften des Transportrades in Eingriff stehen. Dadurch wird gewährleistet, dass die Gurtauflageeinrichtung im freien Zustand, d.h. ohne äußeren Eingriff, bei Betrieb der Zuführeinrichtung in dieser Position gesichert ist, so dass ein ungewolltes Abheben des Bauelementegurtes vom Transportrad durch die Gurtauflageeinrichtung sicher vermieden wird.

Die Zuführeinrichtung kann nach Anspruch 3 auch dahingehend ausgestaltet werden, dass an der Zuführeinrichtung ein Abdeckelement derart vorgesehen ist, dass der Bauelementegurt zwischen der Gurtauflageeinrichtung und dem Abdeckelement verläuft. Das Abdeckelement schützt den Bauelementegurt und die darunter liegende Mechanik der Zuführeinrichtung vor Beschädigung und Verschmutzung. Das Abdeckelement ist in derselben Richtung wie die Gurtauflageeinrichtung beweglich gelagert und wird durch eine zweite Feder derart belastet, dass es die Gurtauflageeinrichtung und den dazwischen liegenden Bauelementegurt in einem freien Zustand in eine Position drängt, in der die Perforationen mit den Stiften des Transportrades in Eingriff stehen. Dadurch wird sichergestellt, dass der Bauelementegurt, beispielsweise bei Betrieb der Zuführeinrichtung, sicher mit den Stiften des Transportrades in Kontakt steht und sich nicht ungewollt vom Transportrad löst.

Eine Ausgestaltung der Zuführeinrichtung nach Anspruch 4 ist dadurch gekennzeichnet, dass die Gurtauflageeinrichtung mittels eines Koppelelements derart mit dem Abdeckelement gekoppelt werden kann, dass die Gurtauflageeinrichtung zusammen mit dem Abdeckelement bewegt werden kann. Diese Anordnung hat den Vorteil, dass durch Betätigung des in der Regel besser zugänglichen Abdeckelements auch gleichzeitig die Gurtauflageeinrichtung bewegt werden kann. Dadurch wird die Bedienungsfreundlichkeit spürbar gesteigert.

In der Ausgestaltung nach Anspruch 5 ist an der Zuführeinrichtung ein Hebel zur Betätigung des Abdeckelements vorgesehen. Der Hebel kann dabei an einer für den Bediener gut zugänglichen Stelle an der Zuführeinrichtung platziert werden, wodurch eine bequeme Betätigung des Abdeckelements und der Gurtauflageeinrichtung möglich ist, ohne dass der Bediener diese direkt berühren muss.

Der Arretiermechanismus gemäß einer Ausgestaltung nach Anspruch 6 erlaubt es, dass der Hebel in einer Position, in der das Abdeckelement von dem Bauelementegurt abgehoben ist, selbsttätig gehalten wird. Die Perforationen des Bauelementegurts können in dieser Position noch mit den Stiften des Transportrads in Eingriff stehen, werden aber durch das Abdeckelement nicht mehr auf die Stifte gedrückt. Dadurch, dass die Perforationen in dieser Position mit den Stiften in Eingriff stehen, der Bauelementegurt aber nicht mehr zwischen der Gurtauflageeinrichtung und dem Abdeckelement klemmt, ist es beispielsweise einfacher möglich, eine Abdeckfolie des Bauelementegurts abzuziehen.

Gemäß Anspruch 7 ist der Arretiermechanismus der Zuführeinrichtung derart ausgestaltet, dass der Hebel selbsttätig in einer Position gehalten wird, in der die Perforationen des Bauelementegurts von den Stiften des Transportrads getrennt sind. Dies vereinfacht den Wechsel eines Bauelementegurtes erheblich.

Um eine ungewollte Beschädigung der Zuführeinrichtung zu verhindern, beispielsweise wenn der Bediener vergisst, die Arretierung des Hebels nach Wechsel des Bauelementegurtes wieder zu lösen, ist gemäß der Ausgestaltung nach Anspruch 8 an einem Gehäuse der Zuführeinrichtung ein Begrenzungsmittel vorgesehen, welches den Bewegungsbereich des Abdeckelements und/oder der Gurtauflageeinrichtung begrenzt. Dadurch kann das Abdeckelement und die Gurtauflageeinrichtung nur bis zu einem bestimmten Grad ausgelenkt werden. Durch entsprechende Anpassung des Begrenzungsmittels kann der Bewegungsbereich der Gurtauflageeinrichtung oder des Abdeckelements beliebig eingestellt werden, beispielsweise, um die Störkante des Abdeckelements auf eine maximal erlaubbare Höhe zu begrenzen.

Im Folgenden wird ein vorteilhaftes Ausführungsbeispiel der erfindungsgemäßen Zuführeinrichtung mit Bezug auf die beigefügten Zeichnungen näher erläutert, wobei
Figur 1 eine perspektivische Ansicht eines Ausführungsbeispiels der erfindungsgemäßen Zuführeinrichtung in einem Zustand, in dem die Perforationen des Bauelementegurtes mit den Stiften des Transportrades in Eingriff stehen,
Figur 2 eine seitliche Querschnittsansicht der in Figur 1 dargestellten Zuführeinrichtung,
Figur 3 die Zuführeinrichtung in einem Zustand, in dem die Perforationen des Bauelementegurtes von den Stiften des Transportrades getrennt sind, und
Figur 4 eine seitliche Querschnittsansicht der in Figur 3 dargestellten Zuführeinrichtung darstellen.

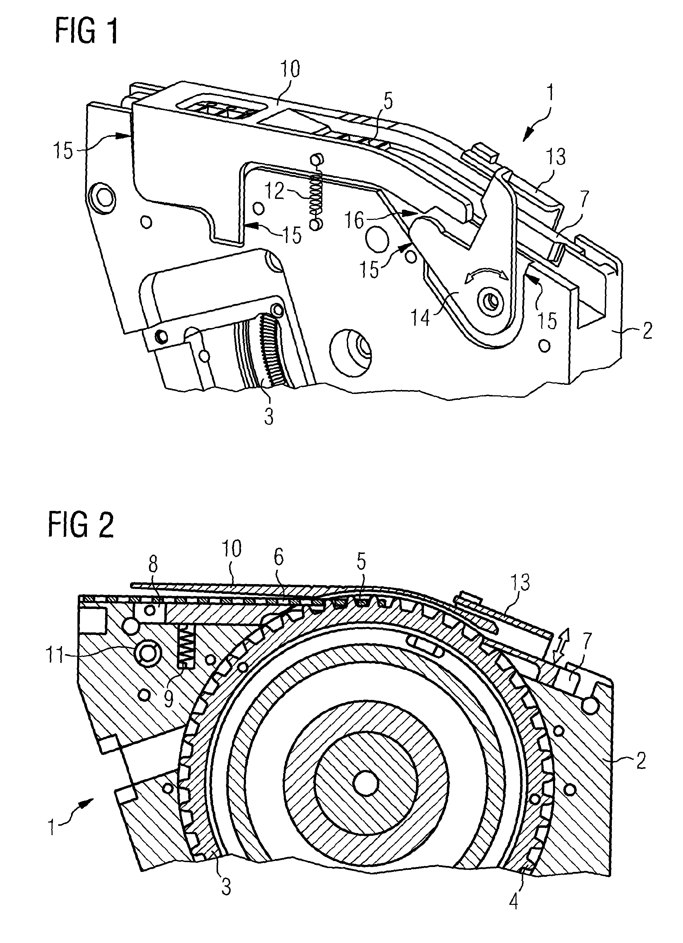

Die Figuren 1 und 2 zeigen ein Ausführungsbeispiel der erfindungsgemäßen Zuführeinrichtung 1 in einem Betriebszustand, wobei Figur 1 eine perspektivische Ansicht und Figur 2 eine seitliche Querschnittsansicht der Zuführeinrichtung 1 darstellen. In einem Gehäuse 2 der Zuführeinrichtung 1 ist ein elektrisch betriebenes Transportrad 3 vorgesehen, an dessen Außenumfang sich zahnartige Stifte 4 radial erstrecken. Ein Bauelementegurt 5, in dem elektrische Bauelemente in taschenartigen Vertiefungen in definiertem Abstand hintereinander gelagert sind, wird in einer kanalartigen Vertiefung an der Oberseite der Zuführeinrichtung 1 geführt. Der Bauelementegurt 5 weist seitliche Perforationen 6 auf, deren Abstand mit dem Abstand der Stifte 4 am Transportrad 3 im Einklang stehen. In dem in den Figuren 1 und 2 dargestellten Betriebszustand der Zuführeinrichtung 1 stehen die Perforationen 6 und die Stifte 4 des Transportrades 3 miteinander im Eingriff. Durch Antrieb des Transportrades 3 in einer Förderrichtung des Bauelementegurts 5 werden die Bauelemente schrittartig zu einer Abholposition befördert, wo sie z.B. von einem (nicht dargestellten) Bestückkopf einer Bestückungsmaschine aufgenommen werden.

Die Zuführeinrichtung 1 verfügt des Weiteren über eine Gurtauflageeinrichtung 7, welche sich in der Transportrichtung des Bauelementegurts 5 erstreckt und auf der der Bauelementegurt 5 aufliegt. Wie anhand der Figur 2 zu sehen ist, ist die Gurtauflageeinrichtung 7 über ein erstes Gelenk 8 derart gelagert, dass sie in Figur 2 durch einen Doppelpfeil dargestellte Richtungen bewegt werden kann. Ferner wird die Gurtauflageeinrichtung 7 durch eine erste Feder 9, beispielsweise eine im Gehäuse 2 vorgesehene Spiralfeder derart belastet, dass sie in einem freien Zustand, das heißt ohne äußeren Eingriff, in eine Position gedrängt wird, in der die die Stifte des Transportrads 3 über die Gurtauflageeinrichtung 7 überstehen und die Perforationen 6 des aufliegenden Bauelementegurts 5 mit den Stiften 4 des Transportrades 3 in Eingriff stehen.

Die Zuführeinrichtung 1 weist darüber hinaus ein Abdeckelement 10 auf, welches mittels eines zweiten Gelenks 11 in denselben Richtungen (Doppelpfeil) wie die Gurtauflageeinrichtung 7 beweglich an der Zuführeinrichtung 1 gelagert ist. Das Abdeckelement 10 ist überhalb der Gurtauflageeinrichtung 7 derart angeordnet, so dass der Bauelementegurt 5 zwischen der Gurtauflageeinrichtung 7 und dem Abdeckelement 10 verläuft. Durch die Vorspannung einer zweiten Feder 12 drückt das Abdeckelement 10 in einem freien Zustand, d.h. ohne äußeren Eingriff, den Bauelementegurt 5 so nach unten, dass die Perforationen 6 mit den Stiften 4 des Transportrades 3 zwangsweise in Eingriff gebracht werden. Dadurch wird gewährleistet, dass sich die Perforationen 6 bei Betrieb der Zuführeinrichtung 1 nicht ungewollt aus den Stiften 4 des Transportrades 3 herauslösen.

Es ist jedoch eine Ausgestaltung der Zuführeinrichtung 1 möglich, bei der nur das Abdeckelement 10 entsprechend der obigen Beschreibung durch die zweite Feder 12 belastet und auf die erste Feder 9 der Gurtauflageeinrichtung 7 verzichtet wird. Im freien Zustand wird dabei die Gurtauflageeinrichtung 7 von dem Abdeckelement 10 über den Bauelementegurt 5 soweit nach unten gedrückt, dass die Perforationen des Bauelementegurts 5 sicher mit den Stiften des Transportrads 3 in Eingriff gebracht werden.

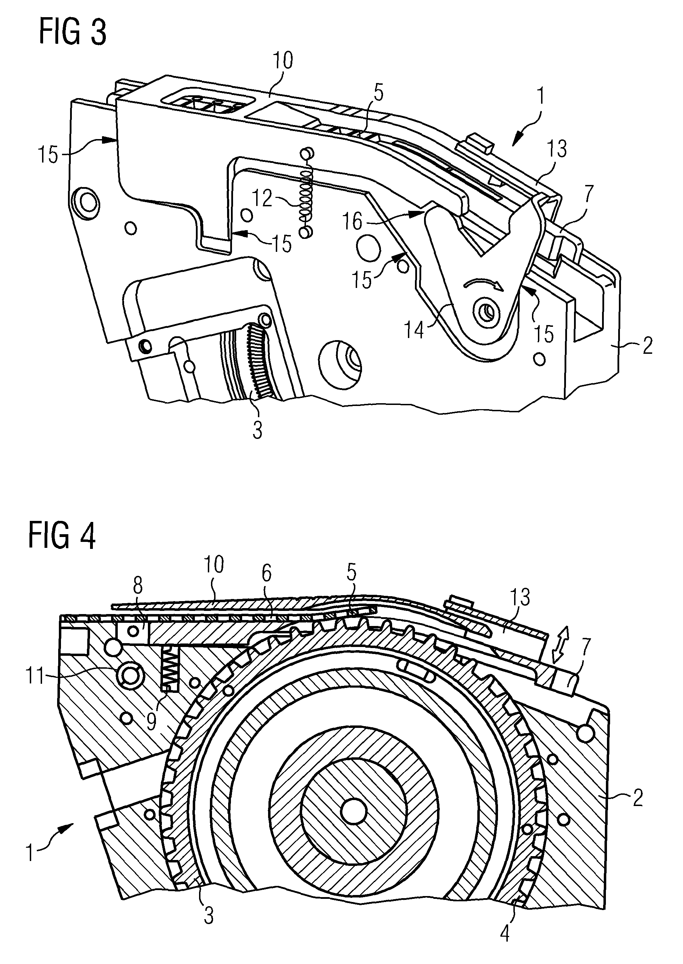

Die Gurtauflageeinrichtung 7 verfügt über ein hakenartiges Koppelelement 13, welches das Abdeckelement 10 seitlich übergreift, wodurch bei einer Bewegung des Abdeckelements 10 nach oben die Gurtauflageeinrichtung 7 mitgenommen wird. Die genaue Funktion des Koppelelements 13 wird bei der Beschreibung der Figuren 3 und 4 näher erläutert.

Wie aus Figur 1 hervorgeht, verfügt die Zuführeinrichtung 1 über einen am Gehäuse 2 vorgesehenen Hebel 14, mit welchem das Abdeckelement 10 in die durch den Doppelpfeil dargestellten Richtungen bewegt werden kann. Durch am Gehäuse 2 der Zuführeinrichtung 1 ausgebildete seitliche Überstände 15, welche als Begrenzungsmittel 15 fungieren, ist sowohl die Bewegungsfreiheit des Hebels 14 als auch des Abdeckelements 10 mechanisch begrenzt. Das Abdeckelement 10 und der Hebel 14 sind in den Bereichen, wo beide in Eingriff gebracht werden, derart ausgebildet, dass sie als Arretiermechanismus 16 fungieren, um das Abdeckelement 10 in einer bestimmten Position selbsttätig zu halten. Durch eine Bewegung des Hebels 14 bis zum Anschlag kann der Arretiermechanismus 16 wieder gelöst werden. Es ist anzumerken, dass die Arretierungsposition durch entsprechende Gestaltung des Hebels 14 und des Abdeckelements 10 so angepasst werden kann, dass selbst, wenn der Bediener vergisst, die Arretierung zu lösen, die Störkante des Abdeckelements 10 eine gewisse kritische Höhe nicht überschreitet, so dass beispielsweise ein Zusammenstoß des Bestückkopfes mit dem Abdeckelement 10 auch in der Arretierungsposition nicht passieren kann.

In den Figuren 3 und 4 ist das Ausführungsbeispiel der Zuführeinrichtung 1 in einer Gurtwechsel-Position dargestellt, wobei Figur 3 eine perspektivische und Figur 4 eine seitliche Querschnittsansicht der Zuführeinrichtung 1 darstellen. Zum Wechsel des Bauelementegurts 5 wird der Hebel 14, wie in Figur 3 dargestellt, in Pfeilrichtung betätigt. Dadurch wird zunächst das Abdeckelement 10 nach oben abgehoben. Nach einer gewissen Strecke kommt das Abdeckelement 10 mit dem hakenförmigen Koppelelement 13 der Gurtauflageeinrichtung 7 in Eingriff, so dass diese zusammen mit dem Abdeckelement 10 auch nach oben bewegt wird. Durch die Bewegung der Gurtauflageeinrichtung 7 wird der zu wechselnde Gurt zwangsweise nach oben bewegt und die Perforationen 6 lösen sich von den Stiften 4 des Transportrades 3. Die zur Begrenzung der Bewegungen des Hebels 14 und des Abdeckelements 10 vorgesehenen seitlichen Überstände 15 am Gehäuse 2 der Zuführeinrichtung 1 müssen dabei so gestaltet werden, dass letztendlich die Gurtauflageeinrichtung 7 weit genug angehoben werden kann, sodass die Perforationen 6 vollständig von den Stiften 4 des Transportrades 3 gelöst werden. In dieser Gurtwechsel-Position, kann der zu wechselnde Gurt sehr einfach aus der Zuführeinrichtung 1 herausgezogen werden. Dieser Vorgang wird auch noch dadurch vereinfacht, dass das Abdeckelement 10 den Bauelementegurt 5 nicht mehr auf die Gurtauflageeinrichtung 7 drückt. Dies ist dadurch zu erklären, dass durch geeignete Gestaltung des Koppelelements 13 die Mitnahme der Gurtaufnahmeeinrichtung erst dann erfolgt, wenn das Abdeckelement 10 schon eine gewisse Strecke bewegt worden ist. Anders gesagt, wird dadurch die Höhe des Kanals, in dem der Bauelementegurt 5 zwischen dem Abdeckelement 10 und der Gurtauflageeinrichtung 7 verläuft, vergrößert.

Nach Herausnehmen des zu wechselnden Bauelementegurts 5 verbleiben das Abdeckelement 10 und der Hebel 14 in der Arretierposition, so dass der Bediener beide Hände frei hat, um einen neuen Bauelementegurt 5 in die Zuführeinrichtung 1 einzuführen. In dieser Arretierposition ist die Gurtauflageeinrichtung 7 immer noch so weit angehoben, dass der Bauelementegurt 5 ohne weiteres in die Zuführeinrichtung 1 eingeführt werden kann, ohne dass die Stifte 4 des Transportrades 3 das Einführen behindern würden. Nach vollständiger Einführung des Bauelementegurts 5 wird der Arretiermechanismus 16 des Hebels 14 gelöst und das Abdeckelement 10 sowie die Gurtauflageeinrichtung 7 werden durch die Federkräfte der ersten Feder 9 und/oder der zweiten Feder 12 jeweils zurück in die Betriebsposition gedrängt. Durch das Absenken des Bauelementegurts 5 kommen die Perforationen 6 wieder in Eingriff mit den Stiften 4 des Transportrades 3 und die Zuführeinrichtung 1 ist wieder betriebsbereit.

Es ist jedoch auch eine Ausgestaltung des Arretiermechanismus 16 denkbar, bei dem im arretierten Zustand nur das Abdeckelement 10 von dem Bauelementegurt 5 abgehoben ist und die Perforationen 6 des Bauelementegurts 5 jedoch noch in Eingriff mit den Stiften 4 des Transportrads 3 stehen. Dies ist vor allem dann zweckmäßig, wenn von einem neu eingeführten Bauelementegurt 5 eine Abdeckfolie, welche das Herausfallen der Bauelemente verhindert, am Anfang des Bauelementegurts 5 abgezogen und mit einer (nicht dargestellten) Abziehvorrichtung in Eingriff gebracht wird. So wird erreicht, dass in der Arretierposition der Bauelementegurt nicht aus der Zuführeinrichtung herausrutscht, gleichzeitig aber das Abdeckelement den Bauelementegurt 5 nicht klemmt.

Obige Beschreibung zeigt, dass durch eine erfindungsgemäße Zuführeinrichtung 1 ein Bauelementegurtwechsel sehr leicht durchgeführt werden kann. Der Hebel 14 kann an einer gut zugänglichen Stelle der Zuführeinrichtung 1 vorgesehen werden, so dass der Bediener nicht gezwungen ist, direkt das Abdeckelement 10 zu betätigen. Des Weiteren ist es bei der erfindungsgemäßen Zuführeinrichtung 1 nicht nötig, den Bauelementegurt 5 unmittelbar händisch von dem Transportrad 3 zu lösen bzw. mit den Stiften 4 des Transportrades 3 in Eingriff zu bringen, so dass ein Verlust von Bauteilen deutlich reduziert werden kann. Durch die Vorsehung von Begrenzungsmitteln 15, welche die Bewegung des Hebels 14 und des Abdeckelements 10 und damit gleichzeitig der Gurtauflageeinrichtung 7 begrenzen, kann eine maximale obere Störkante des Abdeckelements 10 so eingestellt werden, dass selbst dann, wenn das Rückstellen des Abdeckelements 10 in die Betriebsposition vergessen wird, eine Beschädigung der Zuführeinrichtung 1 bzw. eines Bestückkopfes ausgeschlossen werden kann. Dadurch, dass das Abdeckelement 10 bei Betrieb der Zuführeinrichtung 1 den Bauelementegurt 5 von oben auf die Stifte 4 des Transportrades 3 drückt, wird auch immer ein reibungsloser Betrieb der Zuführeinrichtung 1 gewährleistet.

Bezugszeichen:
- 1: Zuführeinrichtung
- 2: Gehäuse
- 3: Transportrad
- 4: Stifte
- 5: Bauelementegurt
- 6: Perforationen
- 7: Gurtauflageeinrichtung
- 8: erstes Gelenk
- 9: erste Feder
- 10: Abdeckelement
- 11: zweites Gelenk
- 12: zweite Feder
- 13: Koppelelement
- 14: Hebel
- 15: Begrenzungsmittel
- 16: Arretiermechanismus

## Patentansprüche

1. Zuführeinrichtung (1) für elektrische Bauelemente, mit einem Transportrad (3) zum Transportieren eines mit Perforationen (6) versehenen Bauelementegurts (5), welches an seinem Außenumfang Stifte (4) aufweist, und mit einer Gurtauflageeinrichtung (7), auf welcher der Bauelementegurt (5) aufliegt, wobei die Gurtauflageeinrichtung (7) und das Transportrad (3) relativ zueinander beweglich gelagert sind, um die Perforationen (6) wahlweise mit den Stiften (4) des Transportrads (3) in Eingriff zu bringen oder von den Stiften (4) zu trennen.

2. Zuführeinrichtung (1) nach Anspruch 1, **dadurch gekennzeichnet, dass** die Gurtauflageeinrichtung (7) beweglich gelagert und mit einer an der Zuführeinrichtung (1) angeordneten ersten Feder (9) derart gekoppelt ist, dass die Federkraft der ersten Feder (9) einer Bewegung der Gurtauflageeinrichtung (7) in einer Richtung, in der die Perforationen (6) von den Stiften (4) getrennt werden, entgegenwirkt.

3. Zuführeinrichtung (1) nach einem der Ansprüche 1 bis 2, **dadurch gekennzeichnet, dass** an der Zuführeinrichtung (1) ein Abdeckelement (10) derart vorgesehen ist, dass der Bauelementegurt (5) zwischen der Gurtauflageeinrichtung (7) und dem Abdeckelement (10) verläuft, wobei das Abdeckelement (10) und die Gurtauflageeinrichtung (7) in derselben Richtung beweglich gelagert sind und das Abdeckelement (7) mit einer an der Zuführeinrichtung (1) angeordneten zweiten Feder (12) derart gekoppelt ist, dass das Abdeckelement (10) aufgrund der Federkraft der zweiten Feder (12) den Bauelementegurt (5) in eine Position drängt, in der die Perforationen (6) mit den Stiften (4) in Eingriff stehen.

4. Zuführeinrichtung (1) nach Anspruch 3, **dadurch gekennzeichnet, dass** die Gurtauflageeinrichtung (7) ein Koppelelement (13) aufweist, um die Gurtauflageeinrichtung (7) derart mit dem Abdeckelement (10) zu koppeln, dass eine Bewegung des Abdeckelements (10) zumindest teilweise auf die Gurtauflageeinrichtung (7) übertragen wird.

5. Zuführeinrichtung (1) nach einem der Ansprüche 3 bis 4, **dadurch gekennzeichnet, dass** an der Zuführeinrichtung (1) ein Hebel (14) zur Betätigung des Abdeckelements (10) vorgesehen ist.

6. Zuführeinrichtung (1) nach Anspruch 5, **dadurch gekennzeichnet, dass** der Hebel (14) einen lösbaren Arretiermechanismus (16) aufweist, um den Hebel (14) in einer Position, in welcher das Abdeckelement (10) vom Bauelementegurt (5) abgehoben ist, zu arretieren.

7. Zuführeinrichtung (1) nach Anspruch 6, **dadurch gekennzeichnet, dass** der Hebel (14) durch den Arretiermechanismus (16) in einer Position arretierbar ist, in welcher die Perforationen (6) von den Stiften (4) getrennt sind.

8. Zuführeinrichtung (1) nach einem der Ansprüche 3 bis 7, **dadurch gekennzeichnet, dass** ein an einem Gehäuse (2) der Zuführeinrichtung (1) vorgesehenes Begrenzungsmittel (15) die Bewegung der Gurtauflageeinrichtung (7) und/oder des Abdeckelements (10) zumindest in der Richtung, in der die Perforationen (6) von den Stiften (4) getrennt werden, begrenzt.
